# EUROPÄISCHE PATENTANMELDUNG

(11) **EP 4 209 796 A1**
(43) Veröffentlichungstag der Anmeldung: **12.07.2023**
(21) Anmeldenummer: 22150337.8
(22) Anmeldetag: 05.01.2022
(51) Int. Cl.: G01R 33/28

(54) **VERFAHREN ZUR LOKALISIERUNG EINES OBJEKTS IM UMFELD EINER EIN MAGNETISCHES STREUFELD ERZEUGENDEN VORRICHTUNG, ANORDNUNG UND OBJEKT**

(71) Anmelder: Siemens Healthcare GmbH, 91052 Erlangen (DE)
(72) Erfinder: Ruf, Marcel, 91094 Langensendelbach (DE); Horn, Felix, 91154 Roth (DE); Schmidt, Verena, 92681 Erbendorf (DE)

(57) **Zusammenfassung**

Verfahren zur Lokalisierung eines Objekts (3) im Umfeld einer ein magnetisches Streufeld (4) erzeugenden Vorrichtung (2), wobei das Objekt (3) eine wenigstens einen Magnetfeldsensor (7) umfassende Sensoreinrichtung (6) aufweist, wobei in Abhängigkeit einer Streufeldinformation, welche den räumlichen Verlauf des Streufelds (4) zumindest innerhalb eines Bereichs (9) beschreibt, und wenigstens eines mit der Sensoreinrichtung (6) gemessenen Messwerts, welcher eine ortsabhängige Eigenschaft des Streufelds (4) beschreibt, wenigstens eine die Position und/oder die Orientierung des Objekts (3) in dem Bereich (9) beschreibende Objektinformation ermittelt wird.

## Beschreibung

Die Erfindung betrifft ein Verfahren zur Lokalisierung eines Objekts im Umfeld einer ein magnetisches Streufeld erzeugenden Vorrichtung. Weiterhin betrifft die Erfindung eine Anordnung umfassend eine Vorrichtung, ein Objekt und eine Steuereinrichtung sowie ein Objekt für eine solche Anordnung.

Bei einer ein magnetisches Streufeld erzeugenden Vorrichtung kann es sich beispielsweise um einen Magnetresonanztomographen (MRT) handeln, welcher prinzipbedingt ein starkes Magnetfeld in seinem Inneren erzeugt. Dabei wird ein solcher Magnetresonanztomograph in der Regel trotz sorgfältiger Abschirmung bzw. Shimming-Maßnahmen auch von einem magnetischen Streufeld umgeben.

Im Umfeld eines solchen Magnetresonanztomographen kann es vielfältige Anwendungen geben, in denen eine Lokalisierung eines Objekts erforderlich ist. Beispielsweise können sich selbst bewegende Objekte, z. B. autonom fahrende Patientenliegen oder Ähnliches, auf eine Positions- und Orientierungsbestimmung zur Durchführung des autonomen Fahrbetriebs angewiesen sein. Dabei stellt sich jedoch insbesondere im Umfeld von Vorrichtungen, welche ein magnetisches Streufeld erzeugen, die Problematik, dass die für die Lokalisierung im Rahmen der selbstständigen Bewegung erforderliche Sensorik dem magnetischen Streufeld ausgesetzt ist. Um dabei Funktionsbeeinträchtigungen von Standard-Sensorik zu vermeiden, können besondere Abschirmmaßnahmen oder Ähnliches erforderlich sein, wodurch der Aufwand für die Bereitstellung eines solchen Systems steigt.

Es besteht daher ein Bedarf für ein verbessertes Verfahren zur Lokalisierung eines Objekts im Umfeld einer ein magnetisches Streufeld erzeugenden Vorrichtung.

Zur Lösung dieser Aufgabe ist bei einem Verfahren der eingangs genannten Art erfindungsgemäß vorgesehen, dass das Objekt eine wenigstens einen Magnetfeldsensor umfassende Sensoreinrichtung aufweist, wobei in Abhängigkeit einer Streufeldinformation, welche den räumlichen Verlauf des Streufelds zumindest innerhalb eines Bereichs beschreibt, und wenigstens eines mit der Sensoreinrichtung gemessenen Messwerts, welcher eine ortsabhängige Eigenschaft des Streufelds beschreibt, wenigstens ein die Position und/oder die Orientierung des Objekts in dem Bereich beschreibende Objektinformation ermittelt wird.

Das zu lokalisierende Objekt umfasst also eine Sensoreinrichtung, welche einen oder mehrere Magnetfeldsensoren aufweist. Über diese Sensoreinrichtung kann wenigstens ein Messwert ermittelt werden, welcher eine ortsabhängige und insbesondere vektorielle Eigenschaft des Streufelds beschreibt. Unter zusätzlicher Berücksichtigung der Streufeldinformation, welche den räumlichen Verlauf des Streufelds bzw. den räumlichen Verlauf der auch über die Sensoreinrichtung erfassbaren Eigenschaft des Streufelds beschreibt, ist eine Positionsermittlung und/oder eine Ermittlung der Orientierung des Objekts in dem Bereich als Objektinformation möglich. Es ist dabei ausreichend, wenn die Streufeldinformation das Streufeld zumindest innerhalb eines begrenzten Bereichs, in dem die Lokalisierung erfolgen soll, beschreibt.

Bei der ein magnetisches Streufeld erzeugenden Vorrichtung kann es sich erfindungsgemäß um eine Magnetresonanztomographie-Einrichtung (MRT-Einrichtung) handeln. Bei dem Objekt kann es sich erfindungsgemäß um eine Patientenliege und/oder ein einer MRT-Einrichtung zugeordnetes Zubehörteil handeln. Es ist jedoch auch möglich, dass das Verfahren bei anderen Arten von ein magnetisches Streufeld erzeugenden Vorrichtungen und/oder bei anderen Arten von Objekten eingesetzt wird.

Die Erfindung beruht auf der Erkenntnis, dass das eigentlich unerwünschte Streufeld einer MRT-Einrichtung, welches außerhalb der auch als Bore bezeichneten Patientenaufnahme und somit in der Umgebung der MRT-Einrichtung vorhanden ist, vorteilhaft für die Lokalisierung eines Objekts verwendet werden kann. Der Verlauf eines solchen Streufelds ist für eine MRT-Einrichtung grundsätzlich bekannt und kann beispielsweise berechnet und/oder durch Messung ermittelt werden.

Die Streufeldinformation kann den räumlichen Verlauf des Streufelds zumindest innerhalb eines sich in der unmittelbaren Umgebung der MRT-Einrichtung erstreckenden Bereichs, beispielsweise innerhalb eines Behandlungsraums, in dem die MRT-Einrichtung angeordnet ist, beschreiben. Das stationäre magnetische Streufeld ist bei einer klinischen MRT-Einrichtung insbesondere stationär und kann beispielsweise magnetische Flussdichten von bis zu mehreren 100 mT aufweisen.

Die Positionsbestimmung oder die Orientierungsbestimmung des Objekts mithilfe des magnetischen Streufelds sowie des Magnetfeldsensors ermöglicht es, auch weitere Funktionalitäten des Objekts, welche eine Positions- und/oder Orientierungsbestimmung des Objekts voraussetzen, auf Grundlage der ermittelten Objektinformation umzusetzen. Beispielsweise kann, wie nachfolgend genauer beschrieben wird, für eine Patientenliege auch ein autonomes oder zumindest teilautonomes Fahrmanöver, beispielsweise eine Auto-Docking-Funktion, also das selbständige Heranfahren und Andocken einer Patientenliege an einer MRT-Einrichtung ausgehend von einer variablen Ausgangsposition, mithilfe der erfindungsgemäß ermittelten Objektinformation vorteilhaft umgesetzt werden.

Gegenüber der Verwendung von herkömmlichen Standard-Sensoren zur Abstands-, Positions- und/oder Orientierungsermittlung, wie beispielsweise, Radar- und Lidarsensoren, Ultraschallsensoren zweidimensionalen oder dreidimensionalen Kameraanordnungen, taktilen Sensoren, kapazitiven Näherungssensoren oder Ähnlichem, bietet die Verwendung eines Magnetfeldsensors in Kombination mit der den räumlichen Verlauf des Streufelds beschreibenden Streufeldinformation vielfache Vorteile.

Gegenüber abstrahlenden Abstandssensoren wie Radarsensoren, Lidar-Sensoren oder Ultraschallsensoren hat die Verwendung des Magnetfeldsensors den Vorteil, dass der Sensorbetrieb passiv ist und somit keine elektromagnetischen oder akustischen Wellen abgestrahlt werden müssen. Bedingt durch das passive Messprinzip sind im Vergleich zu radarbasierten Anwendungen keinerlei Funkzulassungen oder anderweitige regulatorische Zulassungen notwendig, so dass der Aufwand und die Kosten zur Realisierung des Verfahrens erheblich verringert werden können. Ferner ergeben sich bei einem Magnetfeldsensor, verglichen beispielsweise mit einem Lidarsensor, auch keinerlei Sicherheitsanforderungen aus Laser-Schutzklassen oder Ähnlichem. Magnetfeldsensoren sowie die gegebenenfalls zur Auswertung der Magnetfeldsensoren verwendete Elektronik sind vergleichsweise kostengünstig und in unterschiedlichen Konfigurationen bzw. Gehäuseformen oder Ähnlichem realisierbar.

Ferner ermöglicht es die Verwendung des Magnetfeldsensors unmittelbar eine Position zu bestimmen, was sich bei Abstandssensoren prinzipbedingt als aufwändig darstellt, da unter Umständen eine Startposition zunächst unbekannt ist und somit, beispielsweise im Rahmen einer Bahnplanung für eine Bewegung des Objekts, erst aus den Abständen zu weiteren Gegenständen oder Ähnlichem ermittelt werden muss.

Kamerasysteme zur Positionsbestimmung sind vergleichsweise aufwändig zu realisieren und erfordern neben einer oder mehreren Kameras eine vergleichsweise aufwändige Auswertung der aufgenommenen Bilddaten. Ferner benötigen sie eine freie Sicht, welche insbesondere im Umfeld einer MRT-Einrichtung durch Decken, Schläuche oder Ähnliches beeinträchtigt sein kann. Demgegenüber können ein Magnetfeldsensor sowie die Auswertung der von ihm ermittelten Messwerte aufwandsarm und somit kostengünstig umgesetzt werden. Darüber hinaus ist das Streufeld über den Magnetfeldsensor im Wesentlichen unbeeinträchtigt von Drittgegenständen erfassbar.

Taktile Sensoren erfordern zur Positionsbestimmung einen unmittelbaren Kontakt zu einem Drittgegenstand, was sie für eine insbesondere stationäre Lokalisierung oder für eine Lokalisierung während eines Bewegungsbetriebs wenig geeignet macht. Die Wechselwirkung aus dem Streufeld und dem wenigstens einen Magnetsensor, welche erfindungsgemäß zur Lokalisierung eingesetzt wird, ist vorteilhaft jedoch nicht von Drittgegenständen abhängig.

Kapazitive Näherungs- bzw. Proximity-Sensoren weisen nur eine vergleichsweise geringe Reichweite auf und eignen sich somit nicht zur Lokalisierung im freien Raum, insbesondere im Rahmen eines eine Bewegung über mehrere Meter beinhaltenden Bewegungsbetriebs, welcher im Umfeld einer MRT-Einrichtung erforderlich sein kann. Demgegenüber erlaubt es die Verwendung des Streufelds und des Magnetsensors auch in größeren Entfernungen zu der Vorrichtung und/oder zu Drittgegenständen eine Lokalisierung vorzunehmen, insbesondere da beispielsweise bei einer MRT-Einrichtung ein vergleichsweise hohes und damit auch im Abstand von mehreren Metern unterscheidbar zu detektierendes Streufeld vorliegt.

Erfindungsgemäß kann vorgesehen sein, dass als Streufeldinformation eine durch Messung und/oder Berechnung erzeugte Karte des Streufelds verwendet wird, wobei die Karte einen ortsabhängigen, insbesondere absoluten oder normierten, Gradienten und/oder eine ortsabhängige Höhe der magnetischen Flussdichte des Streufels beschreibt.

Ein magnetisches Streufeld, welches von einer Vorrichtung wie einer MRT-Einrichtung erzeugt wird, weist grundsätzlich einen Gradienten auf, das heißt mit größerer Entfernung zu der das Magnetfeld erzeugenden Vorrichtung nimmt die Amplitude des Streufelds, bzw. die magnetische Flussdichte, ab. Der räumliche Verlauf des Streufeldes lässt sich berechnen bzw. durch Messung bestimmen und zumindest für einen beschränkten räumlichen Bereich als Karte darstellen. Die Karte kann dabei insbesondere unterschiedlichen Entfernungen zu der Vorrichtung in wenigstens zwei, bevorzugt drei, Raumrichtungen jeweils den Gradienten und/oder die magnetische Flussdichte, insbesondere als vektorielle Größe, zuordnen, so dass eine Lokalisierung beispielsweise relativ zu der Vorrichtung erfolgen kann.

Eine MRT-Einrichtung kann bei unterschiedlichen magnetischen Flussdichten, beispielsweise bei magnetischen Flussdichten von 0,55 T, 1,5 T, 3 T oder anderen Werten, arbeiten. Es ist dabei möglich, dass die Streufeldinformation das Streufeld in absoluten Werten wiedergibt, welche von der von der MRT-Einrichtung erzeugten Flussdichte abhängig sind. Zusätzlich oder alternativ dazu kann das Streufeld auch normiert angegeben werden, so dass eine Positions- und/oder Orientierungsbestimmung beispielsweise über relative Änderungen von wenigstens zwei erfassten Messwerten ermittelt wird.

In einer bevorzugten Ausgestaltung der Erfindung kann vorgesehen sein, dass der Messwert einen mit dem Magnetfeldsensor gemessenen lokalen Gradienten des Streufelds und/oder eine mit dem Magnetfeldsensor gemessenen lokale magnetische Flussdichte des Streufelds beschreibt. Je nach Ausführung des Magnetfeldsensors kann beispielsweise ein lokaler Gradient direkt als ein Messwert erfasst werden oder es können zwei an unterschiedlichen Positionen bzw. nach einer Bewegung des Objekts erfasste Messwerte der magnetischen Flussdichte herangezogen werden, um einen lokalen Gradienten zu bestimmen.

Die magnetische Flussdichte kann durch den Magnetfeldsensor insbesondere vektoriell gemessen werden. Der ermittelte lokale Gradient und/oder die ermittelte lokale Feldstärke können anschließend mit der Streufeldinformation verglichen werden, so dass eine Zuordnung des Messwerts an zumindest eine Position bzw. einen Teilbereich des von der Streufeldinformation abgedeckten Bereichs möglich ist.

In einer bevorzugten Ausgestaltung der Erfindung kann vorgesehen sein, dass als Magnetfeldsensor ein insbesondere eine magnetische Flussdichte in drei Raumrichtungen ermittelnder Hall-Sensor verwendet wird. Über einen eine magnetische Flussdichte in drei Raumrichtungen ermittelnden Hall-Sensor, welcher auch als dreidimensionaler bzw. dreiachsiger Hall-Sensor bezeichnet werden kann, kann insbesondere entlang von drei Raumrichtungen jeweils wenigstens eine Amplitude einer magnetischen Flussdichte ermittelt werden. Dies ermöglicht insbesondere eine vektorielle Bestimmung der magnetischen Flussdichte bzw. gegebenenfalls eine Bestimmung eines Gradienten der Flussdichte.

Erfindungsgemäß kann vorgesehen sein, dass eine Sensoreinrichtung verwendet wird, welche mehrere versetzt zueinander angeordnete Magnetfeldsensoren umfasst, wobei die Objektinformation in Abhängigkeit von mehreren, über die mehreren Magnetfeldsensoren gemessenen Messwerten ermittelt wird. Dabei kann an mehreren Stellen des Objekts jeweils ein Magnetfeldsensor angeordnet sein, so dass durch die jeweils erhaltenen Messwerte in einfacher Weise die Position und die Orientierung des Objekts ermittelt werden können. Bei einem als Patientenliege ausgebildeten Objekt können die Sensoren beispielsweise an den Ecken der Patientenliege angeordnet sein, so dass diese räumlich beabstandet sind. Die Verwendung von mehreren Sensoren vereinfacht insbesondere das Ermitteln einer eindeutigen Position bzw. einer eindeutigen Orientierung des Objekts, insbesondere wenn keine oder nur wenige, weitere Informationen zu Ermittlung der Objektinformation herangezogen werden.

In einer bevorzugten Ausgestaltung der Erfindung kann vorgesehen sein, dass das Objekt zur Durchführung eines automatischen und/oder teilautomatischen Bewegungsbetriebs zumindest in einem Teil des Bereichs, insbesondere entlang einer Trajektorie, ausgebildet ist, wobei sich das Objekt in Abhängigkeit der Objektinformation bewegt, und/oder dass das Objekt eine Höhenverstellungseinrichtung zur automatischen Einstellung einer Höhe des Objekts aufweist, wobei die Höhe des Objekts in Abhängigkeit der Objektinformation eingestellt wird.

Durch die Bewegung des Objekts verändert sich die Position der Magnetfeldsensoren innerhalb des Streufelds. Basierend auf der jeweils durch insbesondere fortlaufend ermittelte Objektinformationen beschriebenen Positionen und/oder Orientierungen des Objekts kann beispielsweise mittels eines Regelalgorithmus ein Zielpunkt bzw. eine Zielposition sukzessive unter einem vorgegebenen Winkel angefahren und/oder eine vorgegebene Bewegungstrajektorie abgefahren werden, so dass das Objekt insbesondere relativ zu der Vorrichtung angeordnet werden kann.

Die Trajektorie kann beispielsweise in Abhängigkeit einer als Startposition erfassten Objektinformation berechnet oder aus einer hinterlegten Gruppe von Trajektorien ausgewählt werden. Das Objekt kann sich während des Bewegungsbetriebs zumindest durch einen Teil des Bereichs bewegen, in dem die Streufeldinformation das Streufeld angibt, da für diesen Bereich die Zuordnung des Messwerts bzw. der Messwerte der Sensoreinrichtung über die Streufeldinformation zu einer Position bzw. Orientierung des Objekts möglich ist.

Zusätzlich oder alternativ zu einer Bewegungseinrichtung für einen automatischen und/oder teilautomatischen Bewegungsbetrieb kann das Objekt auch eine Höhenverstellungseinrichtung aufweisen, über die automatisch eine Höhe des Objekts, insbesondere eine Höhe einer Liegefläche bzw. eines Patiententisches eines als Patientenliege ausgebildeten Objekts, eingestellt werden kann. Die Einstellung kann dabei vorteilhaft in Abhängigkeit der Objektinformation erfolgen, welche insbesondere auch eine Höhe des Objekts, bzw. des wenigstens einen Magnetfeldsensors, beinhalten kann, wenn beispielsweise eine vertikale Komponente der magnetischen Flussdichte und/oder des Gradienten des Streufelds ermittelt wird.

Die automatische Einstellung der Höhe des Objekts kann beispielsweise vor, während und/oder nach einem Bewegungsbetrieb des Objekts vorgenommen werden. Die Höheneinstellung in Abhängigkeit der Objektinformation ermöglicht vorteilhaft eine präzise Höheneinstellung, insbesondere eines Tisches einer als Patientenliege ausgebildeten Objekts, sodass die Patientenliege bzw. der Tisch der Patientenliege bei einem Andocken an einer MRT-Einrichtung in das Bore der MRT-Einrichtung einfahren kann. Daraus ergibt sich ein Workflow-Vorteil, der auch Risiken des Hochfahrens nahe am Bore, beispielsweise eine Quetschgefahr, minimiert. Vorteilhaft kann die automatische Einstellung der Höhe des Objekts während einem Bewegungsbetrieb des Objekts erfolgen, so dass die Höheneinstellung keine zusätzliche Zeit beansprucht.

Erfindungsgemäß kann vorgesehen sein, dass die Objektinformation in Abhängigkeit einer einen durch das Objekt befahrbaren Teil des Bereichs beschreibenden Bereichsinformation ermittelt wird. Wenn der von dem Objekt befahrbare Teil des Bereichs, für den die Streufeldinformation das Streufeld angibt, beispielsweise aufgrund anderer Umstände, wie weiterer angeordneter Gegenstände, Wände oder Ähnliches, beschränkt ist, so kann durch das Verwenden einer Bereichsinformation die Positionsbestimmung über die Magnetfeldsensoren verbessert werden, da nicht von dem Objekt befahrbare Bereiche bei der Positionsermittlung bereits ausgeschlossen werden können. Somit wird die Zuordnung eines Messwerts zu einer bestimmten Position mithilfe der Streufeldinformation vereinfacht, da insbesondere bestimmte, aufgrund des Messwerts mögliche Positionen ausgeschlossen werden können, wenn diese nicht durch das Objekt befahrbar sind.

In einer bevorzugten Ausgestaltung der Erfindung kann vorgesehen sein, dass der Bewegungsbetrieb des Objekts ausgehend von einer definierten Startposition in dem Bereich und/oder ausgehend von einem definierten Start-Teilbereich des Bereichs erfolgt, wobei die Ermittlung der Ortsinformation auf den Teil des Bereichs beschränkt wird, welcher zwischen der Startposition und/oder dem Start-Teilbereich und einer Zielposition des Bewegungsbetriebs liegt. Die Beschränkung der Ermittlung der Objektinformation auf den Teil des Bereichs, welcher zwischen der Startposition und/oder dem Start-Teilbereich und einer Zielposition des Bewegungsbetriebs liegt, verringert den Suchraum für die Ermittlung der Objektinformationen und vereinfacht somit die Navigation.

Beispielsweise kann ein als autonom fahrende Patientenliege ausgebildetes Objekt an einer Startposition bzw. einem Start-Teilbereich von einem Bediener abgestellt werden, wobei die Patientenliege selbständig mithilfe der Objektinformation in dem automatischen Bewegungsbetrieb eine als MRT-Einrichtung ausgebildete Vorrichtung als Zielposition anfährt. Dabei ist es zum Beispiel möglich, dass ein Bediener einen Patienten auf der Patientenliege nur noch in den Eingangsbereich eines Magnetraums, in dem sich die als MRT-Einrichtung ausgebildete Vorrichtung befindet, schiebt und dann bereits die Tür schließt und sich an ein Bedienpult setzt, während die Patientenliege die letzten Meter zu der MRT-Einrichtung selbsttätig zurücklegt und insbesondere auch das Andocken und/oder Einfahren an die MRT-Einrichtung selbständig im Rahmen eines automatischen Bewegungsbetriebs unter Verwendung der Objektinformation durchführt. Dies kann insbesondere in Klinikanwendungen, in denen ein hoher Durchsatz an Untersuchungen mit einer als MRT-Einrichtung ausgebildeten Vorrichtung erfolgen soll, zu einer Zeitersparnis führen und die Arbeitsabläufe beschleunigen.

Der Eingangsbereich des Magnetraums stellt dabei den Start-Teilbereich des Bereichs dar, von dem aus der Bewegungsbetrieb gestartet wird. Alternativ ist auch das Abstellen an einem definierten und beispielsweise markierten Startpunkt möglich, so dass der Bewegungsbetrieb ausgehend von diesem Startpunkt erfolgen kann. Ein Bereich an der Rückseite der MRT-Einrichtung kann dabei zum Beispiel durch die Beschränkung auf den Teilbereich zwischen dem Startbereich bzw. der Startposition und der MRT-Einrichtung als Zielpunkt bzw. Zielposition unberücksichtigt bleiben, da sich dieser beispielsweise an der der Tür abgewandten Seite befinden kann, so dass ein Anfahren der MRT-Einrichtung aus diesem Bereich ausgeschlossen werden kann.

In einer bevorzugten Ausgestaltung der Erfindung kann vorgesehen sein, dass das Objekt in dem Bewegungsbetrieb an die Vorrichtung angenähert wird, an die Vorrichtung andockt und/oder in die Vorrichtung einfährt. Auf diese Weise kann bevorzugt eine Auto-Docking-Funktion eines als autonom bewegbare Patientenliege ausgebildeten Objekts durchgeführt werden, so dass die Patientenliege selbständig die als MRT-Einrichtung ausgebildete Vorrichtung anfahren kann und insbesondere auch an diese andocken und/oder in die Vorrichtung, beispielsweise ein Bore der MRT-Einrichtung, einfahren kann.

Durch die ermittelte Objektinformation kann das Anfahren in der richtigen Position sowie unter dem richtigen Winkel erfolgen. Vorteilhaft steigt die Genauigkeit, mit der die Objektinformation ermittelt werden kann, dabei mit sinkendem Abstand zu der MRT-Einrichtung an, da die Amplitude des Streufelds immer stärker ansteigt und somit Messtoleranzen des Magnetfeldsensors immer weniger ins Gewicht fallen.

Erfindungsgemäß kann vorgesehen sein, dass für zumindest einen Teil des Bewegungsbetriebs des Objekts, insbesondere in der unmittelbaren Umgebung der Vorrichtung, eine Führungsvorrichtung und/oder eine Abstandsermittlungseinrichtung des Objekts verwendet wird. Bei der Führungsvorrichtung kann es sich beispielsweise um Schienen oder Ähnliches handeln, in die das Objekt einfährt, um das Andocken an der Vorrichtung in einer definierten Position bzw. das korrekte Einfahren in die Vorrichtung zu erleichtern. Über die Führungsvorrichtung kann beispielsweise eine Führung des Objekts für zum Beispiel die letzten 20 cm vor dem vollständigen Andocken erfolgen.

Zusätzlich oder alternativ dazu kann auch eine Abstandsermittlungseinrichtung verwendet werden, um insbesondere im unmittelbaren Umfeld, beispielsweise auf den letzten 20 cm vor dem vollständigen Andocken, die Genauigkeit des Bewegungsbetriebs und/oder die Genauigkeit der Ermittlung der Objektinformation zu steigern. Auch eine Kollisionsschutzfunktion kann über die Abstandsermittlungseinrichtung erfolgen. Dies ist insbesondere vorteilhaft, wenn das Objekt, beispielsweise die Patientenliege, auch für einen Bewegungsbetrieb außerhalb des Bereichs ausgebildet ist und dazu bereits eine Abstandsermittlungseinrichtung, beispielsweise einen Radar, Lidaroder Ultraschallsensor, einen kapazitiven Näherungssensor und/oder einen taktilen Sensor umfasst.

Erfindungsgemäß kann vorgesehen sein, dass das Objekt und/oder die Vorrichtung wenigstens eine Positionsermittlungseinrichtung aufweist, über welche eine zumindest ungefähre Position und/oder Orientierung des Objekts in zumindest einem Anteil des Bereichs beschreibende Positionsinformation ermittelt wird, wobei die Objektinformation in Abhängigkeit der Positionsinformation ermittelt und/oder validiert wird.

Beispielsweise kann vorgesehen sein, dass das Objekt eine Positionsermittlungseinrichtung aufweist, welche auch einen autonomen Fahrbetrieb des Objekts außerhalb des Bereichs, in dem eine Navigation mithilfe des Streufelds und der Magnetfeldsensoren möglich ist, umfasst. Zusätzlich oder alternativ dazu kann auch die Vorrichtung eine Positionsermittlungseinrichtung aufweisen, welche innerhalb eines Teils des Bereichs zusätzlich die Position und/oder Orientierung eines Objekts ermitteln kann. Dies ermöglicht es, dass eine mithilfe der Positionsermittlungseinrichtung bestimmte Positionsinformation zur Ermittlung der Objektinformation herangezogen werden kann und/oder dass eine nur durch die Magnetfeldsensoren und die Streufeldinformation ermittelte Objektinformation mithilfe der Positionsinformation validiert wird.

Der Anteil des Bereichs, in dem die Positionsinformation über die Positionsermittlungseinrichtung erfasst werden kann, muss nicht deckungsgleich mit dem Teil des Bereichs sein, in dem das Objekt einen automatischen oder teilautomatischen Bewegungsbetrieb durchführen kann, es ist insbesondere möglich, dass auch nur für einen Teilbereich des Bewegungsbereichs eine Positionsinformation ermittelbar ist.

Erfindungsgemäß kann vorgesehen sein, dass die Positionsermittlungseinrichtung eine Odometrieeinrichtung des Objekts und/oder wenigstens eine Umfelderfassungseinrichtung des Objekts und/oder der Vorrichtung ist. Mithilfe einer Odometrieeinrichtung kann als Positionsinformation beispielsweise eine zurückgelegte Wegstrecke erfasst werden, welche im Zusammenhang mit einer definierten Startposition und/oder einem definierten Start-Teilbereich, so wie es vorangehend beschrieben wurde, eine zusätzliche Verbesserung der Genauigkeit der Ermittlung der Objektinformation und/oder deren Validierung ermöglicht. Zusätzlich oder alternativ dazu kann als Positionsermittlungseinrichtung auch eine Umfelderfassungseinrichtung wie Umfeldkameras, konventionelle Abstandssensoren wie Ultraschallsensorik oder Ähnliches verwendet werden. Die Umfelderfassungseinrichtung kann dabei ein Teil des Objekts oder ein Teil der Vorrichtung sein und insbesondere auch die vorangehend beschriebene Abstandsermittlungseinrichtung bilden oder diese umfassen.

Erfindungsgemäß kann vorgesehen sein, dass als Vorrichtung eine Magnetresonanztomographie-Einrichtung verwendet wird und/oder dass als Objekt eine Patientenliege und/oder ein der Magnetresonanztomographie-Einrichtung zugeordnetes Zubehörteil verwendet wird.

Für eine erfindungsgemäße Anordnung ist vorgesehen, dass sie eine Vorrichtung, ein Objekt und eine Steuereinrichtung umfasst, wobei die Vorrichtung ein magnetisches Streufeld erzeugt, das Objekt eine wenigstens einen Magnetfeldsensor umfassende Sensoreinrichtung aufweist und die Steuereinrichtung zur Durchführung eines erfindungsgemäßen Verfahrens zur Lokalisierung des Objekts im Umfeld der Vorrichtung eingerichtet ist.

Erfindungsgemäß ist die Steuereinrichtung also dazu eingerichtet bzw. ausgebildet, in Abhängigkeit einer Streufeldinformation, welche den räumlichen Verlauf des Streufelds zumindest innerhalb eines Bereichs beschreibt, und wenigstens eines mit der Sensoreinrichtung gemessenen Messwerts, welcher eine ortsabhängige Eigenschaft des Streufelds beschreibt, wenigstens eine die Position und/oder die Orientierung des Objekts in dem Bereich beschreibende Objektinformation zu ermitteln.

Die Steuereinrichtung kann dabei erfindungsgemäß ein Teil der Vorrichtung, ein Teil des Objekts und/oder eine separate, insbesondere wenigstens mit dem Objekt kommunizierende, Steuereinrichtung sein.

Die Steuereinrichtung ist insbesondere dazu eingerichtet, als Streufeldinformation eine durch Messung und/oder Berechnung erzeugte Karte des Streufelds zu verwenden, wobei die Karte einen ortsabhängigen, insbesondere absoluten oder normierten, Gradienten und/oder eine ortsabhängige Höhe der Flussdichte des Streufelds beschreibt.

Erfindungsgemäß kann dabei der Messwert einen mit dem Magnetfeldsensor gemessenen lokalen Gradienten des Streufelds und/oder eine mit dem Magnetfeldsensor gemessene lokale Feldstärke des Streufelds beschreiben.

Erfindungsgemäß kann vorgesehen sein, dass der Magnetfeldsensor ein insbesondere eine magnetische Flussdichte in drei Raumrichtungen ermittelnder Hall-Sensor ist.

Das Objekt kann erfindungsgemäß eine Sensoreinrichtung umfassen, welche mehrere versetzt zueinander angeordnete Magnetfeldsensoren umfasst, wobei die Objektinformation in Abhängigkeit von mehreren, über die mehreren Magnetfeldsensoren gemessenen Messwerte ermittelbar ist.

Erfindungsgemäß kann das Objekt zur Durchführung eines automatischen und/oder teilautomatischen Bewegungsbetriebs zumindest in einem Teil des Bereichs, insbesondere entlang einer Trajektorie, ausgebildet sein, wobei das Objekt in Abhängigkeit der Objektinformation bewegbar ist. Zusätzlich oder alternativ dazu kann das Objekt eine Höhenverstellungseinrichtung zur automatischen Einstellung einer Höhe des Objekts aufweisen, wobei die Höhe des Objekts in Abhängigkeit der Objektinformation einstellbar ist.

Erfindungsgemäß kann dabei vorgesehen sein, dass die Objektinformation in Abhängigkeit einer einen durch das Objekt befahrbaren Teil des Bereichs beschreibenden Bereichsinformation ermittelbar ist.

Erfindungsgemäß kann vorgesehen sein, dass das Objekt dazu ausgebildet ist, den Bewegungsbetrieb ausgehend von einer definierten Startposition in dem Bereich und/oder ausgehend von einem definierten Start-Teilbereich des Bereichs durchzuführen, wobei die Ermittlung der Ortsinformation auf den Teil des Bereichs beschränkt wird, welcher zwischen der Startposition und/oder dem Start-Teilbereich und einer Zielposition des Bewegungsbetriebs liegt.

Weiterhin kann erfindungsgemäß vorgesehen sein, dass das Objekt in dem Bewegungsbetrieb an die Vorrichtung annäherbar ist, an die Vorrichtung andockbar und/oder in die Vorrichtung einfahrbar ist.

Es kann erfindungsgemäß vorgesehen sein, dass die Anordnung eine Führungsvorrichtung umfasst, welche dazu ausgebildet ist, für zumindest einen Teil des Bewegungsbetriebs des Objekts, insbesondere in der unmittelbaren Umgebung der Vorrichtung, eine Bewegung des Objekts zu führen und/oder dass das Objekt eine Abstandsermittlungseinrichtung aufweist, welche für zumindest einen Teil des Bewegungsbetriebs des Objekts, insbesondere in der unmittelbaren Umgebung der Vorrichtung, verwendbar ist.

In einer bevorzugten Ausgestaltung der Erfindung kann vorgesehen sein, dass das Objekt und/oder die Vorrichtung wenigstens eine Positionsermittlungseinrichtung aufweisen, über welche eine zumindest ungefähre Position und/oder Orientierung des Objekts in zumindest einem Anteil des Bereichs beschreibende Positionsinformation ermittelbar ist, wobei die Steuereinrichtung dazu eingerichtet ist, die Objektinformation in Abhängigkeit der Positionsinformation zu ermitteln und/oder zu validieren.

Die Positionsermittlungseinrichtung kann erfindungsgemäß eine Odometrieeinrichtung des Objekts und/oder wenigstens eine Umfelderfassungseinrichtung des Objekts und/oder der Vorrichtung sein.

Sämtliche vorangehend in Bezug zu dem erfindungsgemäßen Verfahren beschriebenen Vorteile und Ausgestaltungen gelten entsprechend auch für die erfindungsgemäße Anordnung und umgekehrt.

Für ein erfindungsgemäßes Objekt für eine erfindungsgemäße Anordnung ist vorgesehen, dass das Objekt als Patientenliege oder als ein einer MRT-Einrichtung zugeordnetes Zubehörteil ausgebildet ist.

Sämtliche vorangehend in Bezug zu dem erfindungsgemäßen Verfahren oder der erfindungsgemäßen Anordnung beschriebenen Vorteile und Ausgestaltungen gelten entsprechend auch für das erfindungsgemäße Objekt und umgekehrt.

Weitere Vorteile und Einzelheiten der vorliegenden Erfindung ergeben sich aus den im Folgenden beschriebenen Ausführungsbeispielen sowie anhand der Zeichnungen. Dabei zeigen:
- Fig. 1: eine schematische Darstellung eines Ausführungsbeispiels einer erfindungsgemäßen Anordnung zur Erläuterung eines Ausführungsbeispiels eines erfindungsgemäßen Verfahrens, und
- Fig. 2: ein Ausführungsbeispiel eines erfindungsgemäßen Objekts.

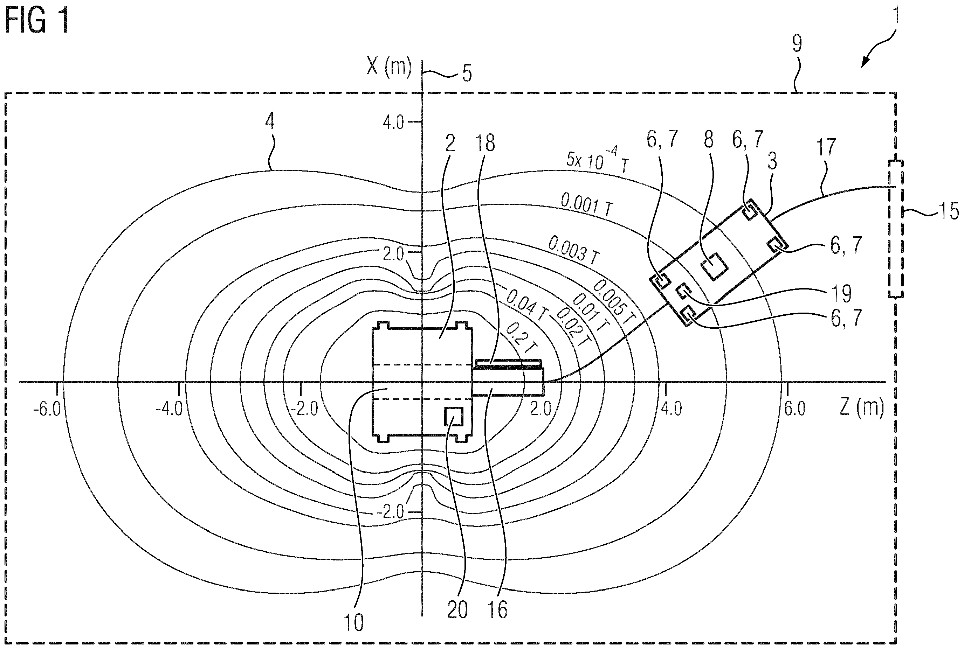

In Fig. 1 ist ein Ausführungsbeispiel einer Anordnung 1 umfassend eine Vorrichtung 2 sowie ein Objekt 3 in Aufsicht dargestellt. Die Vorrichtung 2 ist dabei als eine Magnetresonanztomographie-Einrichtung ausgeführt, welche ein magnetisches Streufeld 4 erzeugt. Von dem magnetischen Streufeld 4 sind schematisch mehrere Feldlinien eingezeichnet und exemplarisch mit zugehörigen magnetischen Flussdichten versehen. Ferner dargestellt ist ein Koordinatensystem 5, in welchem der Verlauf der Feldlinien 4 ortsabhängig in x-Richtung sowie in z-Richtung relativ zu der um den Ursprung des Koordinatensystems 5 herum angeordneten Vorrichtung 2 aufgetragen ist.

Das Objekt 3 ist als eine Patientenliege ausgeführt und beabstandet zu der Vorrichtung 2 angeordnet. Das Objekt 3 umfasst eine Sensoreinrichtung 6, welche mehrere Magnetfeldsensoren 7 aufweist. Das Objekt 3 umfasst weiterhin eine Steuereinrichtung 8, welche zur Durchführung eines Verfahrens zur Lokalisierung des Objekts 3 im Umfeld der das Streufeld 4 erzeugenden Vorrichtung 2 eingerichtet ist. Die Steuereinrichtung 8 ist dazu mit den Magnetfeldsensoren 7 der Sensoreinrichtung 6 verbunden, wobei die Verbindungen der Übersichtlichkeit halber in Fig. 1 nicht dargestellt sind.

Durch die Steuereinrichtung 8 kann in Abhängigkeit einer Streufeldinformation, welche den räumlichen Verlauf des Streufelds 4 zumindest innerhalb eines Bereichs 9 um die Vorrichtung 2 beschreibt, und wenigstens eines mit der Sensoreinrichtung 6 gemessenen Messwerts, welcher eine ortsabhängige Eigenschaft des Streufelds 4 beschreibt, wenigstens eine die Position und/oder die Orientierung des Objekts 3 in dem Bereich 9 beschreibende Objektinformation ermittelt werden. Der Bereich 9 ist schematisch als rechteckiger Bereich um die Vorrichtung 2 dargestellt und kann beispielsweise ein Behandlungs- und/oder Untersuchungsraum sein, in dem die als MRT-Einrichtung ausgebildete Vorrichtung 2 angeordnet ist.

Durch die Magnetfeldsensoren 7 der Sensoreinrichtung 6 wird es ermöglicht, beispielsweise einen Messwert aufzunehmen, welcher einen lokalen Gradienten des Streufeldes 4 und/oder eine lokale magnetische Flussdichte des Streufeldes 4 beschreibt. Auch die Streufeldinformation kann insbesondere einen ortsabhängigen, insbesondere absoluten oder normierten, Gradienten und/oder eine ortsabhängige Höhe der magnetischen Flussdichte des Streufelds beschreiben, so wie es für die Feldlinien und das Koordinatensystem 5 in Fig. 1 schematisch dargestellt ist.

Anhand der beispielsweise von den im vorliegenden Ausführungsbeispiel vier Magnetfeldsensoren 7 gemessenen lokalen Feldstärken des Streufeldes 4 kann sowohl die Position des Objekts 3 als auch dessen Orientierung in Bezug zu dem Streufeld 4 bzw. in Bezug zu der Vorrichtung 2 ermittelt werden. Die Magnetfeldsensoren 7 sind dazu insbesondere zu einer vektoriellen Messung der magnetischen Feldstärken ausgebildet. Beispielsweise können die Magnetfeldsensoren 7 als dreidimensionale Hall-Sensoren bzw. als eine magnetische Flussdichte in drei Raumrichtungen ermittelnde Hall-Sensoren ausgebildet sein.

Es ist möglich, dass die Magnetfeldsensoren 7 derart ausgebildet sind, dass sie einen lokalen Gradienten des Streufelds aus einem einzelnen Messwert bestimmen können. Zusätzlich oder alternativ dazu kann auch die Steuereinrichtung 8 einen lokalen Gradienten aus mehreren, beispielsweise zu unterschiedlichen Zeitpunkten während einer Bewegung des Objekts 3 ermittelten Werten der lokalen magnetischen Flussdichte ermitteln. Dies ermöglicht beispielsweise eine relative Flussdichtenänderung in Bezug zu einem normierten Gradienten für die Positionsbestimmung auszuwerten, so dass die Position und/oder Orientierungsbestimmung des Objekts 3 bzw. die Ermittlung der Objektinformation in gleicher Weise bei MRT-Einrichtungen eingesetzt werden kann, welche Streufelder 4 in unterschiedlicher absoluter Höhe erzeugen können. Dabei kann beispielsweise ein Gradienten-Optimierungsverfahren wie die Suche nach lokalen Maxima angewendet werden, um eine Positions- und/oder Orientierungsbestimmung des Objekts 3, insbesondere während einer Bewegung des Objekts 3, zu ermöglichen. Alternativ kann die Positions- und/oder Orientierungsbestimmung, also die Ermittlung der Objektinformation, auch anhand von der Vorrichtung 2 zugeordneten Absolutwerten erfolgen.

Das von der MRT-Einrichtung erzeugte Streufeld 4 kann von einer maximalen, von der MRT-Einrichtung erzeugbaren Feldstärke im Inneren eines die Patientenaufnahme der MRT-Einrichtung darstellenden Bores 10 abhängen und beispielsweise für MRT-Einrichtungen, welche Felder von zum Beispiel 0,55 T, 1,5 T oder 3 T erzeugen, unterschiedliche Absolutwerte für die magnetische Flussdichte innerhalb des Bereichs 9 aufweisen. Durch das Verwenden eines normierten Gradienten kann vermieden werden, dass auf unterschiedliche Absolutwerte geregelt werden muss, wenn eine Positions- und/oder Orientierungsbestimmung des Objekts 3 beispielsweise im Zuge eines Bewegungsvorgangs des Objekts 3 erfolgen soll.

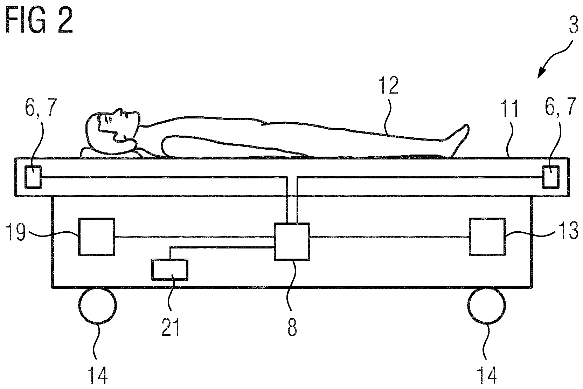

In Fig. 2 ist das als Patientenliege ausgebildete Objekt 3 in einer Seitenansicht dargestellt. Das als Patientenliege ausgebildete Objekt 3 umfasst eine Patientenliegefläche 11, auf der vorliegend ein Patient 12 angeordnet ist. Die Magnetfeldsensoren 7 der Sensoreinrichtung 6 sind vorliegend an den vier Ecken der Patientenliegefläche 11 angeordnet. Auch die Verwendung einer anderen Anzahl an Magnetfeldsensoren 7, beispielsweise von drei oder von mehr als vier, ist möglich.

Das Objekt 3 ist weiterhin zur Durchführung eines automatischen und/oder teilautomatischen Bewegungsbetriebs ausgebildet, wozu beispielsweise die Steuereinrichtung 8 des Objekts 3 oder eine weitere Steuereinrichtung (nicht dargestellt) eine Bewegungseinrichtung 13 des Objekts 3 ansteuern kann, welche Rollen 14 des Objekts 3 antreiben und/oder lenken kann.

Das Objekt 3 ist dazu ausgebildet, den Bewegungsvorgang in Abhängigkeit der Objektinformation, welche aus der beispielsweise in der Steuereinrichtung 8 hinterlegten Streufeldinformation und wenigstens einem mittels der Sensoreinrichtung 6 erfassten Messwerts gewonnen wird, durchzuführen. Dies ermöglicht es, das Objekt 3 in einem insbesondere automatischen oder teilautomatischen Bewegungsvorgang in der Umgebung der Vorrichtung 2 zu bewegen, ohne dass dazu weitere Umgebungssensorik als Teil des Objekts 3 vorgesehen werden muss.

Um eine möglichst präzise Ermittlung der Objektinformation zu ermöglichen, kann vorgesehen sein, dass die Objektinformation durch die Steuereinrichtung 8 in Abhängigkeit einer einen durch das Objekt 3 befahrbaren Teil des Bereichs 9 beschreibenden Bereichsinformation ermittelt wird. Dabei kann für die Ermittlung der Position der Teilbereich des Bereichs 9, in dem sich das Objekt 3 überhaupt befinden kann, durch die Bereichsinformation eingegrenzt werden. Dies ermöglicht es beispielsweise, von vornherein als Positionen und/oder Orientierungen Teilbereiche auszuschließen, welche von dem Objekt 3 nicht befahren werden können, beispielsweise weil sie baulich und/oder durch weitere Objekte blockiert sind.

Ferner kann für die Orientierungs- und/oder Positionsbestimmung des Objekts 3 im Rahmen des Bewegungsbetriebs des Objekts 3 eine definierte Startposition und/oder ein definierter Start-Teilbereich des Bereichs 9 berücksichtigt werden. Beispielsweise ist es möglich, dass die Bewegung des Objekts 3 stets ausgehend von einem, in Fig. 1 schematisch dargestellten, Startbereich 15 erfolgt, in welchem sich beispielsweise eine Tür des als Behandlungsraum ausgebildeten Bereichs 9 befindet. Beispielsweise kann im klinischen Alltag die Patientenliege manuell in den Startbereich 15 bewegt werden, wobei anschließend ein automatischer Bewegungsvorgang des Objekts 3 zum Annähern an die Vorrichtung 2 und/oder zum Andocken und/oder Einfahren in die Vorrichtung 2 durchgeführt wird.

Vorteilhaft kann die Ermittlung der Position und/oder der Orientierung des Objekts 3 daher unter Berücksichtigung des Start-Teilbereichs 15 erfolgen, so dass die Ermittlung der Ortsinformation auf den Teil des Bereichs beschränkt werden kann, welcher zwischen dem Start-Teilbereich 15 und einer anzufahrenden Zielposition 16 liegt. Alternativ zu einem Start-Teilbereich 15 kann auch eine definierte und beispielsweise innerhalb des Bereichs 9 markierte sowie in der Steuereinrichtung 8 hinterlegt Startposition verwendet werden.

Im vorliegenden Ausführungsbeispiel könnte die Ermittlung der Ortsinformation beispielsweise auf positive Werte für die z-Richtung beschränkt werden, wodurch die Zuordnung einer insbesondere vektoriell gemessenen magnetischen Flussdichte und/oder eines lokalen Gradienten an eine Position bzw. eine x-Koordinate und eine z-Koordinate vereinfacht und/oder beschleunigt werden kann.

Während der automatischen und/oder teilautomatischen Bewegung kann das Objekt 3 fortlaufend anhand mehrerer, durch die Steuereinrichtung 8 ermittelten Objektinformationen bewegt werden. Beispielsweise kann eine Zielposition 16 der Bewegung eine unmittelbare Anordnung der Patientenliege vor der MRT-Einrichtung sein. Zusätzlich oder alternativ dazu kann in dem autonomen Bewegungsbetrieb auch ein Einfahren der Patientenliege in das Bore 10 der Vorrichtung 2 erfolgen.

Anhand der mithilfe der Magnetsensoren 7 sowie der Streufeldinformation bestimmten Objektinformation kann das Objekt 3 beispielsweise entlang einer von der Steuereinrichtung 8 ermittelten und/oder in der Steuereinrichtung 8 hinterlegten Trajektorie 17 bewegt werden. Die unterschiedlichen, von dem Magnetsensor 7 gemessenen magnetischen Flussdichten bzw. lokalen magnetischen Gradienten ermöglichen es dabei, beispielsweise mittels eines Regelalgorithmus, das Objekt 3 entlang der Trajektorie 17 zu bewegen. Ein zur Bewegung des Objekts 3 verwendeter Regelalgorithmus kann dabei derart robust ausgeführt werden, dass er individuelle, unvermeidbare Verformungen des Streufelds 4, welche sich z. B. durch metallarmierte Wände des Behandlungsraums oder Ähnliches ergeben können, ausregeln kann.

Vorteilhaft steigt, wie schematisch durch die angegebenen Beispielwerte für die magnetische Flussdichte an den Feldlinien dargestellt ist, die messbare magnetische Flussdichte in der unmittelbaren Umgebung der Vorrichtung 2 immer weiter an, so dass die Positions- und/oder Orientierungsbestimmung mithilfe der Objektinformation immer präziser möglich ist, je näher sich das Objekt 3 an die Vorrichtung 2 bewegt.

Zusätzlich oder alternativ zu der Bewegungseinrichtung 13 kann das Objekt 3 auch eine Höhenverstellungseinrichtung (nicht dargestellt) aufweisen, über die automatisch eine Höhe des Objekts 3, insbesondere ein Abstand der Patientenliegefläche 11 bzw. eines Patiententisches eines als Patientenliege ausgebildeten Objekts 3 vom Boden, eingestellt werden kann. Die Einstellung erfolgt dabei in Abhängigkeit der Objektinformation, welche als Teil der Position des Objekts 3 auch die Höhe des Objekts 3, bzw. des wenigstens einen Magnetfeldsensors 7, beinhaltet sowie gegebenenfalls in Abhängigkeit einer eine einzustellende Zielhöhe beschreibenden Zielhöheninformation, welche in der Steuereinrichtung 8 hinterlegt sein kann und/oder, insbesondere in Abhängigkeit des Typs der anzufahrenden Vorrichtung 2, an diese übermittelt werden kann. Die Höhe des Objekts 3 kann beispielsweise über eine vertikale Komponente der magnetischen Flussdichte und/oder des Gradienten des Streufelds 4 ermittelt und entsprechend über die Höhenverstellungseinrichtung eingestellt werden. Die automatische Einstellung der Höhe des Objekts 3 kann dabei vorteilhaft während dem Bewegungsbetrieb des Objekts 3 erfolgen, sodass die Patientenliegefläche 11 bei einem Andocken an der als MRT-Einrichtung ausgebildeten Vorrichtung 2 direkt in der richtigen Höhe in das Bore 10 einfahren kann.

Um zusätzlich die Präzision eines Andockvorgangs und/oder eines Einfahrvorgangs des Objekts 3 an bzw. in die Vorrichtung 2 zu verbessern, kann eine Führungsvorrichtung 18 verwendet werden, welche beispielsweise eine Schiene oder Ähnliches umfasst und eine Bewegung des Objekts 3, beispielsweise über die letzten 10 cm bis 50 cm vor der Vorrichtung 2, mechanisch führt, um ein präzises Andocken und/oder Einfahren des Objekts 3 in die Vorrichtung 2 zu ermöglichen.

Zusätzlich oder alternativ dazu kann zum Andocken und/oder zur Kollisionsvermeidung beim Andocken auf eine Abstandsermittlungseinrichtung 21 des Objekts 3 eingesetzt werden. Die Abstandsermittlungseinrichtung 21 kann beispielsweise einen Radar, Lidar- oder Ultraschallsensor, einen kapazitiven Näherungssensor oder einen taktilen Sensor umfassen. In unmittelbarer Nähe des Objekts kann der Bewegungsvorgang dabei in Abhängigkeit einer durch die Abstandsermittlungseinrichtung 21 ermittelten Abstandsinformation und/oder durch Ermittlung der für den Bewegungsbetrieb verwendeten Objektinformation zusätzlich in Abhängigkeit der Abstandsinformation durchgeführt werden.

Zusätzlich oder alternativ ist es möglich, dass das Objekt 3 und/oder die Vorrichtung 2 wenigstens eine Positionsermittlungseinrichtung 19, 20 umfassen. Die Positionsermittlungseinrichtung 19 des Objekts 3 kann dabei beispielsweise als eine Odometrieeinrichtung ausgeführt sein. Die Positionsermittlungseinrichtung 20 der Vorrichtung 2 und/oder die oder eine weitere Positionsermittlungseinrichtung 19 des Objekts 3 kann auch als eine Umfelderfassungseinrichtung ausgeführt sein.

Als Umfelderfassungseinrichtung kann dabei beispielsweise eine Umfeldkamera verwendet werden. Die Umfelderfassungseinrichtung kann zusätzlich oder alternativ auch die Abstandsermittlungseinrichtung 21 umfassen oder die Abstandsermittlungseinrichtung 21 des Objekts 3 bilden. Im Fall einer als Teil der Vorrichtung 2 verwendeten Positionsermittlungseinrichtung 20 kann diese mit der Steuereinrichtung 8 des Objekts 3, insbesondere drahtlos, kommunizieren, so dass eine mithilfe der Positionsermittlungseinrichtung 20 der Vorrichtung 2 ermittelte Positionsinformation, welche eine zumindest ungefähre Position und/oder Orientierung des Objekts 3 in zumindest einem Anteil des Bereichs 9 beschreibt, an die Steuereinrichtung 8 übermittelt und von dieser zur Ermittlung und/oder Validierung der Objektinformation verwendet werden kann.

Entsprechend kann die Positionsermittlungseinrichtung 19 des Objektes 3 mit der Steuereinrichtung 8 kommunizieren, so dass entsprechend eine durch diese Positionsermittlungseinrichtung 19 ermittelte Positionsinformation ebenfalls zur Ermittlung der Objektinformation und/oder zu deren Validierung herangezogen werden kann. Eine beispielsweise als Odometrieeinrichtung ausgeführte Positionsermittlungseinrichtung 19 des Objekts 3 kann beispielsweise dazu verwendet werden, zumindest die ungefähre Einfahrposition in den Bereich 9 zu ermitteln und somit beispielsweise einen Start-teilbereich 15 zu bestimmen, wenn dieser nicht fest vorgesehen und/oder in der Steuereinrichtung 8 hinterlegt ist.

Es ist möglich, dass die Steuereinrichtung 8 nicht als Teil des Objektes 3 ausgebildet ist, sondern dass sie ein Teil der Vorrichtung 2 ist und/oder als eine separat angeordnete Steuereinrichtung, welche mit dem Objekt 3 und gegebenenfalls auch mit der Vorrichtung 2 kommuniziert, ausgebildet ist.

Weiterhin ist es möglich, die Ermittlung der Position und/oder der Orientierung des Objekts 3 auch bei einem anderen Typ von Objekt 3 im Umfeld einer insbesondere als Magnetresonanztomographieeinrichtung ausgebildeten Vorrichtung 2 zu verwenden. Das Objekt 3 kann beispielsweise als ein einer Magnetresonanztomographieeinrichtung zugeordnetes Zubehörteil ausgebildet sein. Weiterhin ist es auch möglich, ein entsprechendes Verfahren im Umfeld einer andersartigen Vorrichtung 2, welche ebenfalls ein Streufeld 4 erzeugt, zu verwenden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Lokalisierung eines Objekts (3) im Umfeld einer ein magnetisches Streufeld (4) erzeugenden Vorrichtung (2), wobei das Objekt (3) eine wenigstens einen Magnetfeldsensor (7) umfassende Sensoreinrichtung (6) aufweist, wobei in Abhängigkeit einer Streufeldinformation, welche den räumlichen Verlauf des Streufelds (4) zumindest innerhalb eines Bereichs (9) beschreibt, und wenigstens eines mit der Sensoreinrichtung (6) gemessenen Messwerts, welcher eine ortsabhängige Eigenschaft des Streufelds (4) beschreibt, wenigstens eine die Position und/oder die Orientierung des Objekts (3) in dem Bereich (9) beschreibende Objektinformation ermittelt wird.

2. Verfahren nach Anspruch 1, **dadurch gekennzeichnet, dass** als Streufeldinformation eine durch Messung und/oder Berechnung erzeugte Karte des Streufelds (4) verwendet wird, wobei die Karte einen ortsabhängigen, insbesondere absoluten oder normierten, Gradienten und/oder eine ortsabhängige Höhe der magnetischen Flussdichte des Streufelds (4) beschreibt.

3. Verfahren nach Anspruch 1 oder 2, **dadurch gekennzeichnet, dass** der Messwert einen mit dem Magnetfeldsensor gemessenen lokalen Gradienten des Streufelds (4) und/oder eine mit dem Magnetfeldsensor gemessene lokale magnetische Flussdichte des Streufelds (4) beschreibt.

4. Verfahren nach einem der vorangehenden Ansprüche, **dadurch gekennzeichnet, dass** als Magnetfeldsensor (7) ein insbesondere eine magnetische Flussdichte in drei Raumrichtungen ermittelnder Hall-Sensor verwendet wird.

5. Verfahren nach einem der vorangehenden Ansprüche, **dadurch gekennzeichnet, dass** eine Sensoreinrichtung (6) verwendet wird, welche mehrere versetzt zueinander angeordnete Magnetfeldsensoren (7) umfasst, wobei die Objektinformation in Abhängigkeit von mehreren, über die mehreren Magnetfeldsensoren (7) gemessenen Messwerten ermittelt wird.

6. Verfahren nach einem der vorangehenden Ansprüche, **dadurch gekennzeichnet, dass** das Objekt (3) zur Durchführung eines automatischen und/oder teilautomatischen Bewegungsbetriebs zumindest in einem Teil des Bereichs (9), insbesondere entlang einer Trajektorie (17), ausgebildet ist, wobei das Objekt (3) in Abhängigkeit der Objektinformation bewegt wird, und/oder dass das Objekt (3) eine Höhenverstellungseinrichtung zur automatischen Einstellung einer Höhe des Objekts (3) aufweist, wobei die Höhe des Objekts (3) in Abhängigkeit der Objektinformation eingestellt wird.

7. Verfahren nach Anspruch 6, **dadurch gekennzeichnet, dass** die Objektinformation in Abhängigkeit einer einen durch das Objekt (3) befahrbaren Teil des Bereichs (9) beschreibenden Bereichsinformation ermittelt wird.

8. Verfahren nach einem der Ansprüche 6 oder 7, **dadurch gekennzeichnet, dass** der Bewegungsbetrieb des Objekts (3) ausgehend von einer definierten Startposition in dem Bereich (9) und/oder ausgehend von einem definierten Start-Teilbereich (15) des Bereichs (9) erfolgt, wobei die Ermittlung der Ortsinformation auf den Teil des Bereichs (9) beschränkt wird, welcher zwischen der Startposition und/oder dem Start-Teilbereich (15) und einer Zielposition (16) des Bewegungsbetriebs liegt.

9. Verfahren nach Anspruch 6 bis 8, **dadurch gekennzeichnet, dass** das Objekt (3) in dem Bewegungsbetrieb an die Vorrichtung (2) angenähert wird, an die Vorrichtung (2) andockt und/oder in die Vorrichtung (2) einfährt.

10. Verfahren nach einem der Ansprüche 6 bis 9, **dadurch gekennzeichnet, dass** für zumindest einen Teil des Bewegungsbetriebs des Objekts (3), insbesondere in der unmittelbaren Umgebung der Vorrichtung (2), eine Führungsvorrichtung (18) und/oder eine Abstandsermittlungseinrichtung (21) des Objekts (3) verwendet wird.

11. Verfahren nach einem der vorangehenden Ansprüche, **dadurch gekennzeichnet, dass** das Objekt (3) und/oder die Vorrichtung (2) wenigstens eine Positionsermittlungseinrichtung (19, 20) aufweist, über welche eine zumindest ungefähre Position und/oder Orientierung des Objekts (3) in zumindest einem Anteil des Bereichs (9) beschreibende Positionsinformation ermittelt wird, wobei die Objektinformation in Abhängigkeit der Positionsinformation ermittelt und/oder validiert wird.

12. Verfahren nach Anspruch 11, **dadurch gekennzeichnet, dass** die Positionsermittlungseinrichtung (19, 20) eine Odometrieeinrichtung des Objekts (3) und/oder wenigstens eine Umfelderfassungseinrichtung des Objekts (3) und/oder der Vorrichtung (2) ist.

13. Verfahren nach einem der vorangehenden Ansprüche, **dadurch gekennzeichnet, dass** als Vorrichtung (2) eine MRT-Einrichtung verwendet wird und/oder dass als Objekt (3) eine Patientenliege und/oder ein der MRT-Einrichtung zugeordnetes Zubehörteil verwendet wird.

14. Anordnung umfassend eine Vorrichtung (2), ein Objekt (3) und eine Steuereinrichtung (8), wobei die Vorrichtung (2) ein magnetisches Streufeld (4) erzeugt, das Objekt (3) eine wenigstens einen Magnetfeldsensor (7) umfassende Sensoreinrichtung (6) aufweist und die Steuereinrichtung (8) zur Durchführung eines Verfahrens nach einem der vorangehenden Ansprüche eingerichtet ist.

15. Objekt für eine Anordnung nach Anspruch 14, wobei das Objekt (3) als Patientenliege oder als ein einer MRT-Einrichtung zugeordnetes Zubehörteil ausgebildet ist.
